# EUROPÄISCHE PATENTSCHRIFT

(11) **EP 2 670 880 B1**
(45) Veröffentlichungstag und Bekanntmachung des Hinweises auf die Patenterteilung: **18.07.2018**
(21) Anmeldenummer: 12705067.2
(22) Anmeldetag: 03.02.2012
(51) Int. Cl.: C23C 16/01, C23C 16/04, C23C 16/40, C23C 16/56, C23C 16/455

(54) **VERFAHREN ZUM ERZEUGEN EINER DREIDIMENSIONALEN STRUKTUR SOWIE DREIDIMENSIONALE STRUKTUR**
METHOD FOR PRODUCING A THREE-DIMENSIONAL STRUCTURE AND THREE-DIMENSIONAL STRUCTURE
PROCÉDÉ POUR GÉNÉRER UNE STRUCTURE TRIDIMENSIONNELLE ET STRUCTURE TRIDIMENSIONNELLE

(30) Priorität: 04.02.2011 DE 102011010899
(43) Veröffentlichungstag der Anmeldung: 11.12.2013
(73) Patentinhaber: Fraunhofer-Gesellschaft zur Förderung der angewandten Forschung e.V., 80686 München (DE)
(72) Erfinder: LISEC, Thomas, 25524 Itzehoe (DE); KNEZ, Mato, 06112 HaIIe (DE)
(74) Vertreter: Pfenning, Meinig & Partner mbB
(86) Internationale Anmeldenummer: PCT/EP2012/000696
(87) Internationale Veröffentlichungsnummer: WO 2012/104106

(56) Entgegenhaltungen:
- WO-A1-99/58167
- WO-A1-2007/042373
- WO-A2-02/076631
- US-A1- 2008 193 739

## Beschreibung

Die Erfindung betrifft ein Verfahren zum Erzeugen einer dreidimensionalen Struktur.

Nach dem Stand der Technik sind verschiedene Möglichkeiten zur Erzeugung von dreidimensionalen Strukturen bekannt. Beispielsweise genannt seien verschiedene Spritzgussverfahren. Ein Beispiel für ein Spritzgussverfahren, mit dem besonders präzise Strukturen erzeugt werden können, ist das Pulverspritzgießen.

Es besteht jedoch in verschiedenen technischen Bereichen Bedarf, auch poröse dreidimensionale Strukturen auf einfache und präzise Art herzustellen.

Aus der US 2008/0193739 A1 ist ein Verfahren zur Herstellung eines Verbundmaterials bekannt, bei dem Partikel in eine Füllmatrix eingebettet werden. Dabei wird die Matrix in geschichtete Partikel mit einem Atomlagenverfahren eingebracht.

WO 02/076631 offenbart ein Verfahren zur Herstellung einer Kompositschicht, bei dem die Partikel als Schicht auf ein Substrat aufgebracht werden, die Partikelschicht mit einer ein Matrixmaterial umfassenden Deckschicht überzogen wird und die Kompositschicht durch Energieeinwirkung formiert wird.

WO 99/58167 beschreibt ein Implantat mit einer Kompositbeschichtung.

In der WO 2007/042373 A1 wird ein beschichtetes Medium beschrieben, das Metallpartikel umfasst, die über eine Schicht aus Beschichtungsmaterial beschichtet werden.

Die Aufgabe der Erfindung ist es daher, ein Verfahren zum Erzeugen einer dreidimensionalen Struktur vorzuschlagen, das das Erzeugen von porösen Strukturen ermöglicht und das mit geringem Aufwand durchführbar ist.

Diese Aufgabe wird durch ein Verfahren mit den Merkmalen des Anspruchs 1 sowie durch eine dreidimensionale Struktur mit den Merkmalen des Anspruchs 14 gelöst.

Vorteilhafte Weiterbildungen und Ausgestaltungen ergeben sich mit den Merkmalen der Unteransprüche.

Erfindungsgemäß werden zunächst Partikel auf oder in ein Trägerelement ein- bzw. aufgebracht. Zwischen den Partikeln wird eine Vielzahl zumindest teilweise miteinander verbundener Hohlräume gebildet. Die Partikel treten hierbei an Berührungspunkten miteinander in Kontakt. Das Ein- bzw. Auftragen kann beispielsweise durch Rakeln erfolgen. Die Partikel können beliebige Form und Größe aufweisen.

Nach dem Ein- oder Aufbringen der Partikel werden diese an den Berührungspunkten miteinander verbunden. Hierzu wird die Anordnung aus Partikeln und Trägerelement beschichtet, wobei die Hohlräume zumindest teilweise von der beim Beschichten erzeugten Schicht durchdrungen werden. Die Beschichtung ist bei Raumtemperatur vorzugsweise fest. Besonders bevorzugt ist die Beschichtung im gesamten Temperaturbereich, in dem die dreidimensionale Struktur bestimmungsgemäß verwendet werden soll, fest. Die Beschichtung ist also vorzugsweise nicht als Flüssigkeit ausgebildet. Außerdem weist die Beschichtung vorzugsweise einen bei Raumtemperatur vernachlässigbaren Dampfdruck auf, d.h. sie verdampft bei Raumtemperatur nicht innerhalb
der üblichen Einsatzdauer der dreidimensionalen Struktur. Es handelt sich somit um eine beständige, nicht flüchtige Schicht. Um eine zuverlässige Beschichtung zu gewährleisten, sind die Partikel vor und beim Aufbringen der Beschichtung trocken.

Als Beschichtungsmaterial können bevorzugt jegliche Materialien verwendet werden, die mittels CVD und vorzugsweise mittels ALD bzw. AVD abscheidbar sind. Besonders bevorzugt können anorganische Oxide oder Metalle abgeschieden werden. Als besonders geeignet hat sich Aluminiumoxid erwiesen.

Je nach Ausführungsform können die Hohlräume beim Beschichten offen bleiben, d.h., durch die Beschichtung wird zwar eine Verbindung zwischen den Partikeln bewirkt, der Großteil der Hohlräume zwischen den Partikeln bleibt hierbei jedoch miteinander verbunden. Alternativ kann zumindest ein Teil der Hohlräume von der Schicht verschlossen werden, so dass die Hohlräume geschlossene Poren bilden.

Es sei darauf hingewiesen, dass nicht unbedingt alle eingebrachten Partikel miteinander verbunden werden müssen. Ebenso ist es möglich, dass nur ein Teil der Partikel beim Beschichten verbunden wird, das heißt es ist sowohl ein teilweises als auch ein vollständiges Durchdringen der Hohlräume mit der beim Beschichten erzeugten Schicht möglich. Werden im Wesentlichen alle Partikel miteinander verbunden und somit im Wesentlichen alle Hohlräume durchdrungen, bildet sich zumeist auch auf dem Bereich des Trägerelements eine Schicht, in dem die Partikel auf- bzw. eingebracht sind.

Je nach Anwendungsgebiet können leitende oder nichtleitende Partikel verwendet werden. Auch für die Beschichtung können leitende oder nichtleitende Materialien verwendet werden. Eine Verwendung von leitenden Materialien ist insbesondere dann bevorzugt, wenn die dreidimensionale Struktur als Bestandteil eines mikroelektronischen Bauteils ausgebildet wird.

Als Verfahren zum relativ unkomplizierten und gleichmäßigen Auftragen der Beschichtung ist mittels eines CVD-Verfahrens (chemical vapor deposition) und insbesondere mittels einer Atomlagenabscheidung (ALD) oder mittels Atomarer Dampfphasenabscheidung (AVD) möglich. Die Beschichtung wird also bevorzugt aus der Gasphase abgeschieden. Bei einer Atomlagenabscheidung werden wechselweise zwei verschiedene Komponenten im gasförmigen Zustand eingeleitet, wobei sich diese jeweils an der Oberfläche der Partikel bzw. des Trägerelements anlagern. Bei jedem Anlagerungsvorgang wird eine im Wesentlichen durchgängige ein Atom dicke Schicht gebildet. Hierdurch wird eine besonders gleichmäßige Schicht erzeugt. Eine Schichtdicke wird hierbei hauptsächlich darüber eingestellt, wie oft zwischen einem Einbringen einer ersten Komponente und einem Einbringen einer zweiten Komponente gewechselt wird.

Eine Dicke der aufgebrachten Schicht kann besonders bevorzugt zwischen einer Atomlage und 5 µm, zwischen 5 nm und 1 µm oder zwischen 50 nm und 300 nm betragen. Geringe Schichtdicken haben hierbei den Vorteil, dass sie innerhalb von kurzer Zeit hergestellt werden können, wobei eine poröse Struktur mit besonders niedriger Dichte und hoher Porosität erzeugt wird. Durch Schichtdicken im oberen Bereich der angegebenen Spannen hingegen wird eine besonders feste und zuverlässige Verbindung ermöglicht.

Es sei noch darauf hingewiesen, dass durch die Beschichtung vorzugsweise ein vernachlässigbar geringer Anteil am Volumen der beim Ein- bzw. Aufbringen der Partikel gebildeten Hohlräume eingenommen wird. Ein Volumen der Schicht kann bevorzugt weniger als 1% eines Volumens der Hohlräume betragen.

Bei dem Verfahren können die Partikel mit zufälliger Orientierung und Anordnung auf- bzw. eingebracht werden; ein geordnetes Aufbringen, das mit einem erhöhten Aufwand verbunden wäre, ist also nicht notwendig. Die Partikel weisen bevorzugt einen relativ kleinen Durchmesser von weniger als 20 µm, vorzugsweise weniger als 10 µm und besonders vorzugsweise weniger als 5 µm auf, so dass auch bei einer zufälligen Anordnung der Partikel ein sehr präzises Ausbilden von dreidimensionalen Strukturen möglich ist.

Um eine Beschädigung des Trägerelements und/oder der Partikel beim Beschichten zu vermeiden, ist es vorteilhaft, wenn die Partikel bzw. das Trägerelement bis zu einer Temperatur von mindestens 100°C, vorzugsweise 150°C oder 200°C, wärmebeständig sind. Durch eine derart hohe Wärmebeständigkeit ergeben sich besonders wenige Einschränkungen hinsichtlich der verwendbaren Beschichtungsverfahren. Zugleich ermöglicht die hohe Wärmebeständigkeit eine schnellere Durchführung des Verfahrens, ohne dass eine Beschädigung der Partikel und/oder des Trägerelements durch Überhitzen zu befürchten ist.

Um einen Verlust bzw. eine Verringerung der porösen Eigenschaften zu vermeiden, werden die Partikel beim Verbinden derselben vorzugsweise im Wesentlichen nicht irreversibel verformt.

In einer besonders bevorzugten Ausführungsform wird ein Partikelgemisch mit Partikeln aus mindestens zwei verschiedenen Materialien eingebracht. Die Materialien unterscheiden sich vorzugsweise hinsichtlich mindestens einer physikalischen oder chemischen Eigenschaft. Beispielsweise kann eine Härte, eine elektrische Leitfähigkeit, eine thermische Leitfähigkeit, ein thermischer Ausdehnungskoeffizient und/oder die elektrochemischen Parameter der Partikel unterschiedlich gewählt werden. Durch Verwendung unterschiedlicher Materialien mit auch unterschiedlichen Mischungsverhältnissen und gegebenenfalls unterschiedlichen chemischen und physikalischen Eigenschaften könen die Eigenschaften der dreidimensionalen Struktur präzise und zuverlässig an gewünschte Vorgaben angepasst und eingestellt werden.

Beispielsweise kann ein thermischer Ausdehnungskoeffizient der Partikel bzw. des Partikelgemischs an den thermischen Ausdehnungskoeffizienten des Trägerelements angepasst werden. Ebenso kann der thermische Ausdehnungskoeffizient der Partikel bzw. des Partikelgemischs auch an ein Bauteil angepasst werden, in dem die verbundenen Partikel angeordnet werden sollen.

Je nach Ausführungsform werden entweder nur ein Teil der Partikel oder im Wesentlichen alle ein- bzw. aufgebrachten Partikel miteinander verbunden. Ein Verbinden im Wesentlichen aller Partikel ist insbesondere dann vorteilhaft, wenn eine Struktur des Trägerelements abgeformt werden soll.

Die Partikel können vor dem Beschichten in losem Kontakt miteinander angeordnet sein. Somit sind vor dem Aufbringen der Beschichtung keinerlei zusätzliche Verfahrensschritte zum Herstellen einer Verbindung zwischen den Partikeln notwendig. Nach dem Beschichten ist die so gebildete dreidimensionale Struktur fest.

Je nach Ausführungsform des Verfahrens kann als Trägerelement ein Substrat mit einer auf- oder eingebrachten Höhenstruktur verwendet werden. Diese Struktur wird dann vorzugsweise durch die verbundenen Partikel abgeformt. Unter anderem können Vertiefungen oder Kavitäten als Höhenstruktur in das Substrat eingebracht werden. Ebenso kann auf das Substrat eine Schichtanordnung mit Strukturierung aufgebracht werden. Die Verwendung eines Substrats mit Vertiefungen bietet sich insbesondere bei Anwendungen der dreidimensionalen Struktur in elektronischen Schaltungen an. Hierbei kann durch die verbundenen Partikel eine leitfähige Verbindung zwischen zwei Komponenten ermöglicht werden, die auf gegenüberliegenden Seiten der Vertiefung angeordnet sind.

Als besonders geeignete Substrate haben sich Substrate aus Silizium, Glas oder Keramik herausgestellt. Das Substrat kann beispielsweise als Wafer oder Platte ausgebildet sein. Siliziumwafer sind hierbei besonders für eine Anwendung im Mikroelektronikbereich geeignet.

In einer vorteilhaften Ausführungsform werden Elemente, die deutlich größer als die Partikel sind, eingebettet, so dass diese beim Beschichten mit den Partikeln und dem Trägerelement verbunden werden. Beispielsweise können Chips, insbesondere gedünnte Chips, eingebettet werden. Die beschichteten Partikel können dann einer Kontaktierung der Chips dienen. Hierdurch kann ein einfaches Stapeln und Verbinden von gedünnten Chips ermöglicht werden.

Je nach Ausführungsform kann auf die Anordnung aus Partikeln und Trägerelement zumindest teilweise eine Deckschicht aufgebracht werden, die oberflächennahe Hohlräume im Wesentlichen vollständig verschließen und/oder eine geschlossene Schicht auf einer obersten Lage der Partikel bilden soll. Die Deckschicht wird vorzugsweise nachfolgend, beispielsweise durch Schleifen oder Polieren, planarisiert. Beim Planarisieren der Deckschicht können mit eingebettete größere Elemente, wie beispielsweise Chips, wieder freigelegt werden. Gemäß Anspruch 1 wird nach dem Beschichten und Verbinden der Partikel das Trägerelement und gegebenenfalls die unbeschichtet gebliebenen Partikel zumindest teilweise entfernt. Das Entfernen kann beispielsweise mittels eines Ätzschritts erfolgen. Durch das zumindest teilweise Entfernen des Trägerelements können vielfältige verschiedene dreidimensionale Strukturen erzeugt werden, z.B. kann durch teilweises Entfernen des Trägerelements eine poröse Membran bestehend aus den verbundenen Partikeln gebildet werden. Diese Membran kann beispielsweise von einem durch einen verbleibenden Rest des Trägerelements gebildeten Rahmen gehalten werden. Alternativ zur Erzeugung einer Membran kann durch teilweises Entfernen des Trägerelements eine auf das restliche Trägerelement aufgebrachte freistehende Struktur gebildet werden.

Alternativ ist auch ein vollständiges Entfernen des Trägerelements möglich. Die verbundenen Partikel können dann auf ein anderes Substrat aufgebracht werden. Hierdurch ist ein Abformen einer Oberflächengeometrie des Trägerelements möglich, wobei die entsprechend geformten verbundenen Partikel auf ein anderes Substrat übertragen werden.

In einer weiteren Ausführungsform kann auf die Partikel ein weiteres Material aufgebracht werden, wobei die verbundenen Partikel nachfolgend zumindest teilweise, vorzugsweise durch Ätzen, entfernt werden. Die Partikel können also selbst als eine Opferschicht dienen, wobei ein Entfernen der Opferschicht aufgrund der durch die Partikel gebildeten porösen Struktur besonders einfach und schnell möglich ist.

Zusätzlich zu einem Verfahren zum Herstellen einer dreidimensionalen Struktur wie vorangehend beschrieben betrifft die Erfindung des Weiteren eine durch ein solches Verfahren hergestellte dreidimensionale Struktur. Diese unterscheidet sich gegenständlich von herkömmlich hergestellten dreidimensionalen Strukturen dadurch, dass sie eine Vielzahl von Partikeln umfasst, die durch eine Schicht miteinander verbunden sind. Die Partikel sind hierbei nicht in einer einzelnen Lage angeordnet, sondern eine Größe eines von den verbundenen Partikeln eingenommenen Raumbereichs ist vorzugsweise in alle Richtungen deutlich größer als der Durchmesser eines einzelnen Partikels. Bevorzugt ist der durch die verbundene Partikel eingenommene Raumbereich in jede Raumrichtung größer als ein Fünffaches des Durchmessers der Partikel.

Ausführungsbeispiele der Erfindung werden nachfolgend anhand der Figuren näher erläutert. Es zeigen:
- Fig. 1: eine Darstellung unterschiedlicher Schritte nach einem ersten Ausführungsbeispiel des Verfahrens zur Herstellung einer dreidimensionalen Struktur,
- Fig. 2: eine Darstellung unterschiedlicher Schritte nach einem zweiten Ausführungsbeispiel des erfindungsgemäßen Verfahrens zur Herstellung einer dreidimensionalen Struktur, bei der eine poröse Membran erstellt wird,
- Fig. 3: eine Darstellung unterschiedlicher Schritte nach einem dritten Ausführungsbeispiel des erfindungsgemäßen Verfahrens, bei dem eine freistehende Struktur erzeugt wird,
- Fig. 4: eine Darstellung unterschiedlicher Schritte nach einem vierten Ausführungsbeispiel des erfindungsgemäßen Verfahrens, bei dem verbundene Partikel auf ein anderes Substrat zur Bildung der dreidimensionalen Struktur übertragen werden,
- Fig. 5: eine Darstellung unterschiedlicher Schritte nach einem fünften Ausführungsbeispiel des erfindungsgemäßen Verfahrens zur Herstellung einer dreidimensionalen Struktur, bei dem die Partikel als Opfermaterial dienen und
- Fig. 6: eine Darstellung unterschiedlicher Schritte nach einem sechsten Ausführungsbeispiel des erfindungsgemäßen Verfahrens zur Herstellung einer dreidimensionalen Struktur, bei dem größere Körper zwischen den Partikeln eingebettet werden.

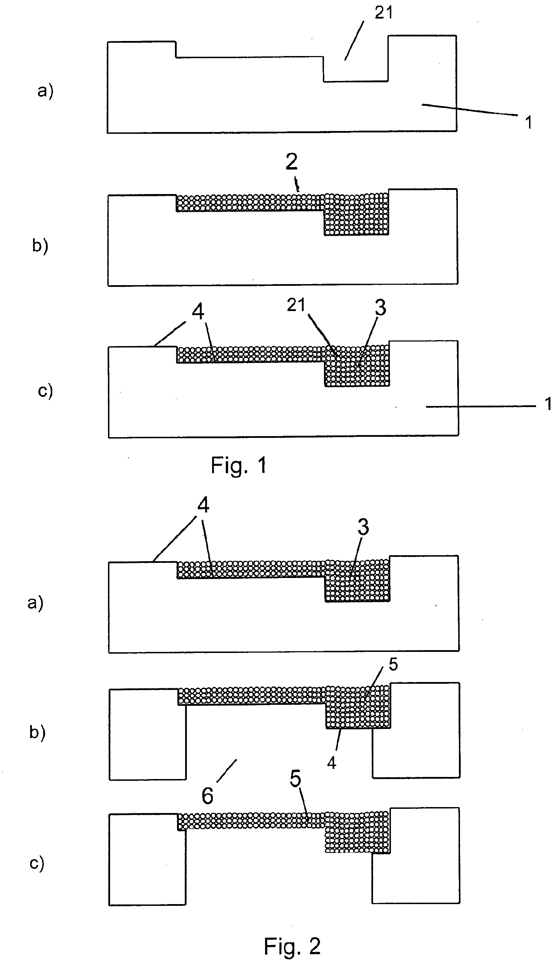

Anhand von Fig. 1 wird eine erste Ausführungsform des Verfahrens verdeutlicht. Durch das Verfahren wird, wie in Figur 1c) zu erkennen, eine dreidimensionale Struktur mit einem Siliziumträger 1, der einen mit verbundenen Partikeln 3 verfüllten Hohlraum 21 aufweist, gebildet.

In einem ersten Verfahrensschritt wird hierzu ein Siliziumsubstrat 1 bereitgestellt, in das eine Vertiefung 21 eingebracht wird. Nachfolgend werden, wie dies in Fig. 1b) zu erkennen ist, Partikel 2 in die Vertiefung 21 eingefüllt, z.B. durch Aufrieseln der Partikel und/oder durch Rakeln. Die Anordnung und Ausrichtung der Partikel 2 zueinander ist hierbei willkürlich.

In einem nachfolgenden Verfahrensschritt wird eine Beschichtung mit einer Dicke von etwa 100 µm durch ein CVD(chemical vapor deposition)-Verfahren, genauer durch Atomlagenabscheidung, aufgebracht. Durch das Beschichtungsmaterial wird nicht nur eine Schicht 4 am Boden der Vertiefung bzw. neben der Vertiefung gebildet, sondern es lagert sich auch an den Partikeln an. Da die Partikel nach dem Einfüllen in die Vertiefung 21 an Berührungspunkten in Kontakt miteinander stehen, führt das Anlagern des Beschichtungsmaterials zu einer Verbindung der Partikel untereinander, so dass sie einen zusammenhängenden Körper aus verfestigten Partikeln 3 bilden. Beim Beschichten werden die Partikel sowie das Trägerelement auf etwa 100 bis 200 °C erwärmt. In entsprechender Weise wird das Material für Partikel und Trägerelement temperaturresistent ausgelegt.

Es sei darauf hingewiesen, dass die Größenverhältnisse in den Figuren lediglich zur Verdeutlichung dienen. Die Vertiefung kann beispielsweise eine Tiefe von etwa 400 µm und eine Breite von etwa 80 µm aufweisen. Als Partikel können beispielsweise Aluminiumoxidpartikel mit einem Durchmesser von 3 µm verwendet werden. Es sind also zumeist deutlich mehr Partikel übereinander angeordnet, als dies in den Figuren zu erkennen ist. Prinzipiell kann eine Form und ein Durchmesser der Partikel jedoch frei gewählt werden.

Ein weiteres Ausführungsbeispiel des erfindungsgemäßen Verfahrens wird nachfolgend anhand von Fig. 2 erläutert. Bei dieser Ausführungsform wird zunächst ein Substrat mit einer verfüllten Vertiefung 21, wie in Zusammenhang mit Fig. 1 beschrieben, hergestellt. In diesem Ausführungsbeispiel können die Prozessparameter des ALD-Verfahrens jedoch auch so gewählt werden, dass die ALD-Schicht 4 die Hohlräume nicht vollständig durchdringt, d.h. es müssen nicht unbedingt alle Partikel miteinander verbunden sein. Anschließend wird, entsprechend Fig. 2b), das Substrat 1 teilweise entfernt, so dass die verdichteten Partikel lediglich am Rand am Substrat befestigt sind, während sie in einem mittleren Bereich 6 eine freitragende Membran 5 bilden. Sollten einige Partikel nicht mit verbunden sein, werden sie in diesem Verfahrensschritt mit entfernt. Die Dicke der freitragenden Membran 5, die beispielsweise etwa 40 µm betragen kann, wird dann durch eine Eindringtiefe der ALD-Schicht in die mit Partikeln 2 gefüllte Vertiefung 21 bestimmt. Diese kann, insbesondere wenn im Wesentlichen alle Partikel verbunden wurden und das Beschichtungsmaterial die Hohlräume bis zum Boden der Vertiefung 21 durchdrungen hat, auf ihrer Rückseite noch mit der im Wesentlichen geschlossenen ALD-Schicht 4, die sich auf der Oberfläche des Substrats 1 beim Aufbringen der Beschichtung gebildet hat, bedeckt sein.

Diese ALD-Schicht 4 wird, soweit vorhanden, im nachfolgenden Verfahrensschritt entfernt. Das Entfernen kann beispielsweise mittels Ionenstrahlätzen erfolgen. Die fertige dreidimensionale Struktur nach diesem Verfahrensschritt ist in Fig. 2c) abgebildet.

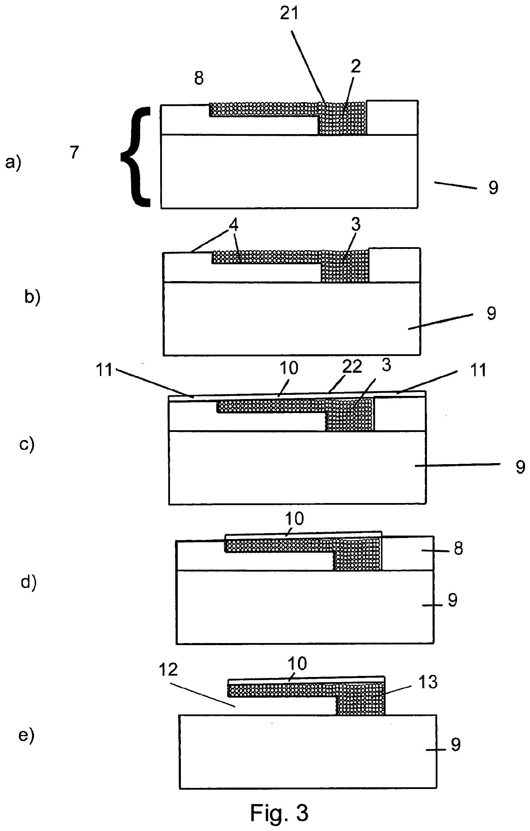

Ein Werkstück nach verschiedenen Schritten eines Verfahrens gemäß einer dritten bevorzugte Ausführungsform der Erfindung ist in Fig. 3 dargestellt. Bei der entsprechenden Verfahrensvariante wird ein Trägerelement 7, bestehend aus einem Siliziumsubstrat 9 und einem Opfermaterial 8, verwendet. Das Opfermaterial 8, beispielsweise ein Photolack, ist nicht durchgängig mit gleicher Dicke aufgebracht, so dass eine Vertiefung 21 gebildet wird. In diese Vertiefung werden, wie bereits in Zusammenhang mit Fig. 1 erläutert, Partikel eingebracht. Auch in dieser Ausführungsform wird anschließend eine Beschichtung mittels eine ALD-Verfahrens abgeschieden. Nachfolgend wird eine Schicht 22, die beispielsweise aus einem Metall bestehen kann, auf die Oberseite der Partikel bzw. des Opfermaterials aufgebracht. Oberflächennahe Hohlräume zwischen Partikeln 2 werden hierbei durch die Schicht 22 verschlossen. Bereiche 11 der Schicht 22, die direkt auf dem Opfermaterial aufliegen, werden nachfolgend entfernt, während die Schicht 22 im Bereich 10 der verbundenen Partikel 3, beispielsweise durch Schleifen oder Polieren, planarisiert wird. Das Entfernen der Bereiche 11 der Schicht 22 kann durch Ionenstrahlätzen erfolgen. Es sind jedoch auch jegliche andere Methoden, die ohne zu starke physikalische Beanspruchung einen präzisen lokalen Materialabtrag ermöglichen, geeignet.

In dem nachfolgenden Verfahrensschritt, der in Fig. 3 im Teil e) dargestellt ist, wird das Opfermaterial 8, beispielsweise mittels eines chemischen Ätzverfahrens, entfernt. Hierdurch bilden die verbundenen Partikel 3 mit der aufgebrachten Schicht 22 eine freistehende Struktur 13, wobei die Struktur 13 in einem Bereich 12 beabstandet zum Substrat 9 verläuft.

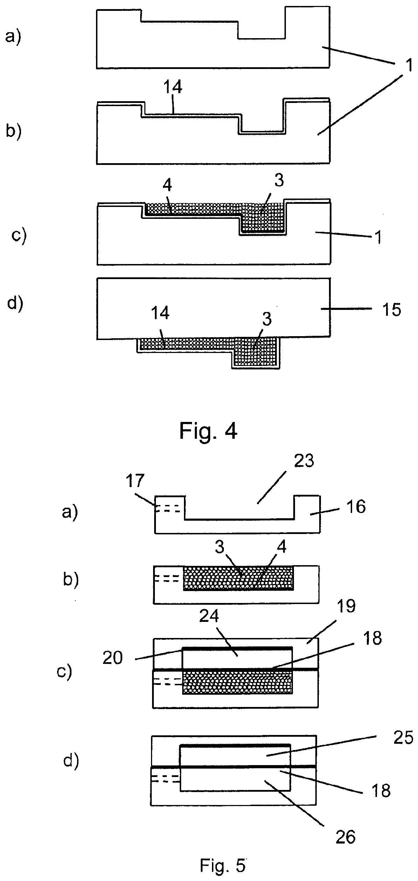

Anhand von Fig. 4 wird eine weitere vorteilhafte Ausführungsform des erfindungsgemäßen Verfahrens verdeutlicht. Die ersten Verfahrensschritte des Verfahrens, deren Ergebnisse in Fig. 4 in den Teilen a) bis c) gezeigt werden, ähneln stark dem Verfahren aus Fig. 1. Im Unterschied zu diesem wird jedoch eine Metallschicht 14 auf die Oberseite des Substrats 1 vor dem Einbringen der Partikel 2 aufgebracht. Nach dem Befüllen der Vertiefung 21 mit Partikeln 2 und Aufbringen der ALD-Schicht 4 zur Bildung eines Körpers aus verfestigten Partikeln 3 wird das Substrat 1 entfernt. Dies kann beispielsweise mittels eines chemischen Ätzschritts erfolgen. Hierzu wird eine Säure ausgewählt, die zwar das Substrat 1 auflöst, jedoch keine Reaktion mit der Metallschicht 14, den verfestigten Partikeln 3 oder der ALD-Schicht 4 eingeht. Nach dem Entfernen des Substrats 1 wird der durch die verfestigten Partikel 3 gebildete und mit der Metallschicht 14 beschichtete Körper zur Bildung der fertigen dreidimensionalen Struktur auf ein anderes Substrat 15 aufgebracht, wobei der Körper so angeordnet wird, dass die Metallschicht 14 von anderen Substrat 15 weg gerichtet ist.

Eine fünfte vorteilhafte Ausführungsform des erfindungsgemäßen Verfahrens kann durch die in Fig. 5 dargestellten Schritte nachvollzogen werden. Bei dieser Verfahrensvariante wird zunächst ein Substrat 16 mit einer Vertiefung 23, die mit einer Bohrung 17 verbunden ist, bereitgestellt. Anschließend werden Partikel in die Vertiefung 23 eingebracht und mittels einer ALD-Schicht verbunden. Die aufgebrachte ALD-Schicht wird neben den verbundenen Partikeln 3 entfernt, so dass das Beschichtungsmaterial nur noch zwischen den Partikeln sowie am Boden der Vertiefung 23 vorliegt. Anschließend wird eine Schicht 18 aufgebracht, die, da in diesen Bereichen die ALD-Schicht zuvor entfernt wurde, neben den verbundenen Partikeln 3 direkt auf dem Substrat 16 aufliegt und die die verbundenen Partikel im Bereich der Vertiefung 23 vollständig überdeckt.

Um eine besonders glatte Schicht 18 zu erzeugen, kann vor dem Aufbringen dieser Schicht (insbesondere vor dem Entfernen der ALD-Schicht neben den verbundenen Partikeln) die Oberfläche der Partikel durch Aufbringen einer Deckschicht und anschließendes Polieren planarisiert werden, wie dies bereits im Zusammenhang mit der Deckschicht 22 in Fig. 3 erläutert wurde. Neben dem Bereich, in dem die Partikel eingebracht sind, wird die Deckschicht dann Zusammen mit der ALD-Schicht entfernt.

In einem nachfolgenden Verfahrensschritt wird ein weiteres Substrat 19, das eine Aushöhlung 24 und an der Decke der Aushöhlung 24 eine Metallschicht 20 aufweist, auf das Substrat 16 mit den in der Vertiefung 23 angeordneten Partikeln 3 und der Schicht 18 aufgesetzt.

Aus der somit gebildete dreidimensionale Struktur werden im hierauf folgenden Verfahrensschritt die verbundenen Partikel 3, die ALD-Schicht 4 sowie gegebenenfalls die zur Ermöglichung einer glatten Schicht 18 zuvor aufgebrachte Deckschicht entfernt. Dies kann beispielsweise durch einen Ätzschritt erfolgen. Aufgrund der Porosität ist ein schnelles Entfernen der Partikel durch Ätzen möglich, obwohl diese lediglich durch die Bohrung 17 zugänglich sind.

Insgesamt wird hierdurch ein Gehäuse bestehend aus den Substraten 16 und 19 gebildet, wobei das Gehäuse eine versiegelte Kammer 25 sowie eine durch die Bohrung 17 mit der Umgebung verbundene Kammer 26 aufweist. Zwischen den Kammern 25 und 26 ist die Schicht 18 angeordnet, die eine in diesem Beispiel gasundurchlässige freitragende Membran bildet. Die Schicht 18 bildet zusammen mit der Metallschicht 20 einen Kondensator, wobei sich eine Kapazität des Kondensators abhängig von einem Umgebungsdruck ändert, so dass die in Fig. 5d) dargestellte Anordnung als Drucksensor verwendet werden kann.

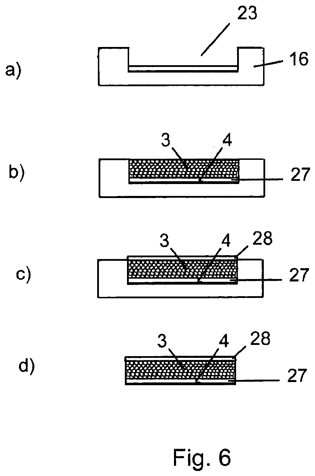

Ein sechstes Ausführungsbeispiel des erfindungsgemäßen Verfahrens wird anhand von Fig. 6 erläutert. Bei diesem Ausführungsbeispiel werden dieselben Verfahrensschritte wie beim ersten Ausführungsbeispiel durchgeführt. Zusätzlich wird jedoch vor dem Einbringen der Partikel 2 ein gedünnter Chip 27 auf dem Boden der Vertiefung 21 angeordnet. Nach dem Verbinden der Partikel wird ein weiterer Chip 28 auf die verbundenen Partikel 3 aufgelegt und an diesen befestigt. Anschließend wird das Substrat 1 und optional die ALD-Schicht 4 entfernt, so dass die beiden Chips 27 und 28 mit den dazwischen angeordneten verbundenen Partikeln 3 als dreidimensionale Struktur verbleiben. Es sei darauf hingewiesen, dass in den genannten Ausführungsbeispielen die Durchmesser der Partikel nahezu beliebig variiert werden können. Auch die Dicke der ALD-Schicht kann über einen breiten Bereich variiert werden. Je nach Dicke der ALD-Schicht und Größe der Partikel können zwischen den Partikeln bestehende Hohlräume miteinander verbunden sein, so dass eine poröse Struktur mit offenen Poren gebildet ist, oder aber auch zumindest teilweise verschlossen sein, so dass durch die verbundenen Partikel ein geschlossenporiges Material gebildet wird.

## Patentansprüche

1. Verfahren zum Erzeugen einer dreidimensionalen Struktur mit den Schritten:
- Auf- oder Einbringen von Partikeln (2) auf oder in ein Trägerelement (1; 7; 16), wobei zwischen den Partikeln (2) eine Vielzahl von zumindest teilweise miteinander verbundener Hohlräume gebildet wird und wobei die Partikel (2) an Berührungspunkten miteinander in Kontakt treten,
- Verbinden der Partikel (2) an den Berührungspunkten durch Beschichten der Anordnung aus Partikeln und Trägerelement, wobei die Hohlräume zumindest teilweise von der beim Beschichten erzeugten Schicht (4) durchdrungen werden, und
wobei nach dem Beschichten und Verbinden der Partikel (2) das Trägerelement (1; 7; 16) und gegebenenfalls die unbeschichtet gebliebenen Partikel (2) zumindest teilweise entfernt werden-und wobei das Beschichten mittels eines CVD-Verfahrens und insbesondere einer Atomlagenabscheidung oder einer atomaren Dampfphasenabscheidung durchgeführt wird.

2. Verfahren nach Anspruch 1, **dadurch gekennzeichnet, dass** die Schicht (4) mit einer Dicke zwischen einer Atomlage und 5 µm, vorzugsweise zwischen 5 nm und 1 µm und besonders vorzugsweise mit einer Dicke zwischen 50 nm und 300 nm ausgebildet wird.

3. Verfahren nach einem der vorangehenden Ansprüche, **dadurch gekennzeichnet, dass** die Partikel (2) und/oder das Trägerelement (1; 7; 16) bis zu einer Temperatur von mindestens 100°C, vorzugsweise 150°C oder 200°C wärmebeständig sind.

4. Verfahren nach einem der vorangehenden Ansprüche, **dadurch gekennzeichnet, dass** ein Partikelgemisch mit Partikeln (2) aus mindestens zwei verschiedene Materialien eingebracht wird.

5. Verfahren nach einem der vorangehenden Ansprüche, **dadurch gekennzeichnet, dass** die Partikel (2) vor dem Beschichten im losen Kontakt miteinander angeordnet sind.

6. Verfahren nach einem der vorangehenden Ansprüche, **dadurch gekennzeichnet, dass** als Trägerelement (1) ein Substrat (1; 7; 16) mit einer auf- oder eingearbeiteten Höhenstruktur, vorzugsweise mindestens einer in das Substrat eingearbeiteten Vertiefung (21; 23) oder Kavität und/oder einer auf das Substrat aufgebrachten Schichtanordnung (8) mit Strukturierung, verwendet wird.

7. Verfahren nach Anspruch 6, **dadurch gekennzeichnet, dass** ein Substrat verwendet wird, das aus Silizium, Glas oder Keramik ausgebildet ist.

8. Verfahren nach einem der vorangehenden Ansprüche, **dadurch gekennzeichnet, dass** Elemente, die mindestens das Zehnfache eines durchschnittlichen Volumens eines Partikels (2) aufweisen, mit eingebettet und beim Beschichten mit den Partikeln (2) und dem Trägerelement (1; 7; 16) verbunden werden.

9. Verfahren nach einem der vorangehenden Ansprüche, **dadurch gekennzeichnet, dass** nach dem Beschichten der Anordnung aus Partikeln (2) und Trägerelement (1) zumindest teilweise eine Deckschicht (22) aufgebracht wird, die oberflächennahe Hohlräume vorzugsweise vollständig verschließt und die besonders vorzugsweise nachfolgend planarisiert wird.

10. Verfahren nach einem der vorhergehenden Ansprüche, **dadurch gekennzeichnet, dass** die verbundenen Partikel (3) nach dem teilweisen Entfernen des Trägerelements (1; 7; 16) eine auf einem restlichen Trägerelement aufgebrachte freistehende Struktur (13) oder eine freitragende Membran (5) bildet.

11. Verfahren nach einem der vorhergehenden Ansprüche, **dadurch gekennzeichnet, dass** das Trägerelement (1; 7; 16) vollständig entfernt wird, wobei die verbundenen Partikel (3) auf ein anderes Substrat (15) aufgebracht werden.

12. Verfahren nach einem der vorangehenden Ansprüche, **dadurch gekennzeichnet, dass** auf die verbundenen Partikel ein weiteres Material (18) aufgetragen wird, wobei die verbundenen Partikel (3) nachfolgend zumindest teilweise, vorzugsweise durch Ätzen, entfernt werden.

13. Verfahren nach einem der vorangehenden Ansprüche, **dadurch gekennzeichnet, dass** beim Beschichten eine beständige nicht flüchtige Schicht, vorzugsweise aus einem durch ein CVD-Verfahren wie beispielsweise ALD oder AVD aufbringbaren Material und besonders vorzugsweise aus einem Metall oder einem anorganischen Oxid wie beispielsweise Aluminiumoxid, erzeugt wird.

14. Dreidimensionale Struktur, hergestellt mit dem Verfahren nach einem der vorangehenden Ansprüche.

## Claims

1. Method for producing a three-dimensional structure having the steps:
- Adding or applying particles (2) on or into a carrier element (1; 7; 16), a plurality of at least some interlinked cavities being formed between the particles (2) and the particles (2) coming into contact with one another at points of contact,
- Connecting the particles (2) to one another at the points of contact by coating the arrangement of particles and carrier element, at least some of the cavities being penetrated by the layer (4) produced during the coating process,
wherein after the particles have been coated and connected the carrier element (1; 7; 16) and, if applicable, the particles (2) not being coated are removed, at least partly, and wherein the coating process is performed by means of a CVD method and in particular by means of atomic layer deposition or atomic vapor deposition.

2. Method in accordance with claim 1, **characterized in that** the layer (4) has a thickness of between one atom layer and 5 µm, preferably between 5 nm and 1 µm, and particularly preferably between 50 nm and 300 nm.

3. Method in accordance with any of the foregoing claims, **characterized in that** the particles
(2) and/or the carrier element (1; 7; 16) are heat-resistant up to a temperature of at least 100 °C, preferably 150 °C or 200 °C.

4. Method in accordance with any of the foregoing claims, **characterized in that** a particle mixture having particles (2) made of at least two different materials is added.

5. Method in accordance with any of the foregoing claims, **characterized in that** prior to coating the particles (2) are arranged in loose contact with one another.

6. Method in accordance with any of the foregoing claims, **characterized in that** a substrate (1; 7; 16) having an applied or added height structure, preferably at least a depression (21; 23) or cavity added to the substrate and/or a structured layer arrangement (8) applied to the substrate, is used for the carrier element (1).

7. Method in accordance with claim 6, **characterized in that** a substrate is used that is embodied from silicon, glass, or ceramic.

8. Method in accordance with any of the foregoing claims, **characterized in that** elements that
have at least ten times the average volume of a particle (2) are also embedded and during the
coating process are connected to the particles (2) and the carrier element (1; 7; 16).

9. Method in accordance with any of the foregoing claims, **characterized in that** after the arrangement of particles (2) and carrier element (1) have been coated, a cover layer (22) is applied, at least in part, that preferably completely closes the shallow cavities and that particularly preferably is subsequently planarized.

10. Method in accordance with any of the foregoing claims, **characterized in that** after some of the carrier element (1; 7; 16) has been removed, the connected particles (3) form a self-supporting structure (13) on a remainder of the carrier element or form a self-supporting membrane (5).

11. Method in accordance with claim 14, **characterized in that** the carrier element (1; 7; 16) is completely removed, the connected particles (3) being applied to a different substrate (15).

12. Method in accordance with any of the foregoing claims, **characterized in that** another material (18) is applied to the connected particles, at least some of the connected particles (3) being subsequently removed, preferably by etching.

13. Method in accordance with any of the foregoing claims, **characterized in that** during the coating process a stable non-volatile layer is produced, preferably from a material that can be applied using a CVD method such as for instance ALD or AVD and particularly preferably from a metal or an inorganic oxide such as for instance aluminum oxide.

14. Three-dimensional structure produced with the method in accordance with any of the foregoing claims.

## Revendications

1. Procédé de production d'une structure tridimensionnelle, comportant les étapes suivantes :
- mise en place ou introduction de particules (2) sur ou dans un élément support (1 ; 7 ; 16), ce à l'occasion de quoi un grand nombre de cavités au moins partiellement reliées les unes aux autres sont formées entre les particules (2), et les particules (2) entrent en contact les unes avec les autres en des points de contact,
- liaison des particules (2) aux points de contact, par revêtement de l'arrangement des particules et de l'élément support, les cavités étant au moins partiellement traversées par la couche (4) produite lors du revêtement, et
dans lequel, après revêtement et liaison des particules (2), l'élément support (1 ; 7 ; 16) et éventuellement les particules (2) restant non revêtues sont au moins partiellement éliminés, le revêtement étant mis en oeuvre par un procédé CVD et en particulier par un dépôt par couches atomiques, ou par un dépôt d'atomes en phase vapeur.

2. Procédé selon la revendication 1, **caractérisé en ce que** la couche (4) est réalisée avec une épaisseur comprise entre une couche atomique et 5 µm, de préférence entre 5 nm et 1 µm et d'une manière particulièrement préférée avec une épaisseur comprise entre 50 nm et 300 nm.

3. Procédé selon l'une des revendications précédentes, **caractérisé en ce que** les particules (2) et/ou l'élément support (1 ; 7 ; 16) résistent à la chaleur jusqu'à une température d'au moins 100 °C, de préférence 150 °C ou 200 °C.

4. Procédé selon l'une des revendications précédentes, **caractérisé en ce qu'**on introduit un mélange de particules constitué de particules (2) en au moins deux matériaux différents.

5. Procédé selon l'une des revendications précédentes, **caractérisé en ce que** les particules (2) sont, avant le revêtement, disposées en contact lâche les unes avec les autres.

6. Procédé selon l'une des revendications précédentes, **caractérisé en ce qu'**on utilise en tant qu'élément support (1) un substrat (1 ; 7 ; 16) présentant une structure en hauteur, mise en place ou introduite, de préférence avec au moins un renfoncement (21 ; 23) ou une cavité, introduit dans le substrat, et/ou un arrangement de couches (8), avec structuration, mis en place sur le substrat.

7. Procédé selon la revendication 6, **caractérisé en ce qu'**on utilise un substrat qui est constitué de silicium, de verre ou de céramique.

8. Procédé selon l'une des revendications précédentes, **caractérisé en ce qu'**on incorpore ensemble des éléments présentant un volume au moins égal à dix fois le volume moyen d'une particule (2), et, lors du revêtement, on les relie aux particules (2) et à l'élément support (1 ; 7 ; 16).

9. Procédé selon l'une des revendications précédentes, **caractérisé en ce que**, après le revêtement de l'arrangement de particules (2) et de l'élément support (1), on met en place au moins partiellement une couche de couverture (22), qui de préférence obture complètement les cavités proches de la surface, et qui d'une manière particulièrement préférée est ensuite planarisée.

10. Procédé selon l'une des revendications précédentes, **caractérisé en ce que** les particules liées (3) forment, après l'élimination partielle de l'élément support (1 ; 7 ; 16), une structure autonome (13), mise en place sur le reste de l'élément support, ou une membrane (5) autoportante.

11. Procédé selon l'une des revendications précédentes, **caractérisé en ce qu'**on élimine complètement l'élément support (1 ; 7 ; 16), les particules liées (3) étant mises en place sur un substrat différent (15).

12. Procédé selon l'une des revendications précédentes, **caractérisé en ce qu'**on met en place sur les particules liées un matériau supplémentaire (18), les particules liées (3) étant ensuite éliminées au moins partiellement, de préférence par attaque chimique.

13. Procédé selon l'une des revendications précédentes, **caractérisé en ce que**, lors du revêtement, il y a production d'une couche résistante non volatile, de préférence constituée d'un matériau pouvant être mis en place par un procédé CVD, tel que par exemple un procédé ALD ou AVD, et d'une manière particulièrement préférée d'un métal ou d'un oxyde inorganique tel que par exemple l'oxyde d'aluminium.

14. Structure tridimensionnelle, fabriquée par le procédé selon l'une des revendications précédentes.
